# EUROPEAN PATENT SPECIFICATION

(11) **EP 0 720 223 B1**
(45) Date of publication and mention of the grant of the patent: **26.03.2003**
(21) Application number: 94830591.7
(22) Date of filing: 30.12.1994
(51) Int. Cl.: H01L 23/31, H01L 23/29, H01L 23/532

(54) **Process for the production of a semiconductor device having better interface adhesion between dielectric layers**
Herstellungsverfahren für Halbleiteranordnung mit besserer Haftung zwischen dielektrischen Lagen
Procédé de fabrication pour un dispositif semi-conducteur comportant une adhésion améliorée entre les couches diélectriques

(43) Date of publication of application: 03.07.1996
(73) Proprietor: STMicroelectronics S.r.l., 20041 Agrate Brianza (Milano) (IT)
(72) Inventor: Bacchetta, Maurizio, I-20093 Cologno (Milano) (IT); Zanotti, Luca, I-20013 Crema (CR) (IT); Queirolo, Giuseppe, I-20100 Milano (IT)
(74) Representative: Botti, Mario

(56) References cited:
- EP-A- 0 274 274
- EP-A- 0 479 127
- EP-A- 0 627 763
- WO-A-90/09883
- US-A- 5 304 394
- PATENT ABSTRACTS OF JAPAN vol. 18, no. 518 (E-1612) 29 September 1994 & JP-A-06 181 201 (KAWASAKI STEEL) & DATABASE WPI Week 9430, Derwent Publications Ltd., London, GB; AN 94-246345 & JP-A-6 181 201
- PATENT ABSTRACTS OF JAPAN vol. 14, no. 491 (M-1040) 25 October 1990 & JP-A-02 200 454 (NEC) & DATABASE WPI Week 9038, Derwent Publications Ltd., London, GB; AN 90-285971 & JP-A-2 200 454 (NEC)

## Description

### Field of application

The present invention relates to a method for manufacturing a semiconductor device having improved adhesion at the interface between layers of dielectric material, of the type comprising the steps of forming a first layer of dielectric material on at least one part of a structure defined in a substrate of semiconductor material and forming a second layer of dielectric material superimposed on at least one zone of the first layer.

The present invention also relates to a semiconductor device achievable by said method.

The present invention also relates to a ternary dielectric compound of silicon, oxygen and carbon and particularly indicated for use as an adhesion layer between superimposed dielectric materials.

### Prior art

In present electronic and optoelectronic technology the importance of the dielectric materials used in the realisation of so-called semiconductor devices is well known. By this term is indicated a device whose operation utilises the physical properties of a semiconductor material which is a constitutive part of it. A semiconductor device can for example include in the microelectronics field one or more integrated electronic circuits formed in a semiconductor material.

In a semiconductor device layers of dielectric materials have insulation functions, electrical and thermal, between different zones of the device or between the device and the external environment and/or act as barriers for contaminating substances coming from the external environment.

Typical dielectric materials in the specific field of microelectronics, i.e. of integrated circuits, are silicon oxides, doped or not, silicon oxynitrides and silicon nitrides.

In the structure of an integrated circuit a certain number of layers of dielectric material are commonly superimposed. In the different manufacturing steps of the integrated electronic device these layers, identical or different in composition, are formed in succession. This happens e.g. in some passivation steps, final, intermediate or intermetal, i.e. between two metallization levels of the device. The insulating ability of a multilayer is greater than that of a single layer. Often after formation of a layer and before formation of the next layer there are performed intermediate operations. For example there is formed a so-called sacrificial layer which is then totally or partly removed, or it is the first layer which is partially removed. In any case the successive layer has portions of surface in contact at least partially with the layer or layers immediately underlying.

The requirement for good operation of the circuit and hence integrity of the semiconductor device makes it necessary that the layers of dielectric material be very adherent in the contact zones. However, as known, in present technology it sometimes happens that the layers of superimposed dielectric materials exhibit adhesion problems and tend to detach themselves. This phenomenon is known as peeling.

The interpretation of this problem is not yet sufficiently clear or complete for those skilled in the art.

The problem of poor adhesion exists primarily due to the fact that the materials are in the form of layers. Each material in layer form exhibits indeed an internal stress which causes curving of the layer when superimposed on another layer. If the stress is particularly high so as to generate at the interface forces greater than the adhesion forces between the layers, peeling occurs.

A very important cause of the failed adhesion are the present techniques for layer formation.

As known, the layers of dielectric material except the first, which commonly can be obtained thermally, are formed by deposition. The technique most commonly used is chemical deposition in vapour phase, known as CVD (Chemical Vapour Deposition). Chemical precursors of the elements it is desired to deposit are reacted in gaseous state in a reactor. Usually a chemical precursor is used for each of the elements included in the compound to be formed.

A dielectric deposited by the CVD technique is not perfectly uniform in structure and composition along the direction of deposition even if the process parameters are well controlled. In particular if the Plasma Enhanced CVD (PECVD) technique is used, in which a specific reactor is used and the reactive species are generated in the form of plasma in the reaction chamber, in the first stages of the deposition the parameters of deposition are not fully controllable. Between ignition of the plasma and the stationary state of operation of the reactor there is a brief period of settlement before the deposition speed reaches steady state. The structural and compositional non-uniformity in the surface regions obstructs adhesion of the successive layer to the surface on which takes place the deposition.

In addition it is necessary to allow for the fact that saturation of the surface bonds due to the presence of spurious atoms or even mere interruption of the deposition process, makes more difficult adhesion with the successive layer. This can happen e.g. in the case where the free surface has been subjected to a previous treatment such as a chemical etching for removal of a sacrificial layer before deposition of the successive layer.

The different manufacturing steps of the device fulfil another important role in aggravating the adherence difficulties. Mechanical stresses generate internal stress, e.g. during the separation phase of the individual devices by cutting the semiconducting chip on which are formed different integrated circuits. In addition, allowance must be made for temperature variations and attacks of contaminants from the external environment which can occur during the circuit manufacturing cycle. These effects act in the direction of degradation of the interlayers bonds.

It is known experimentally that the lack of adhesion is more or less acute depending on the composition and structure of the materials making up the layers. On the other hand known techniques for improving adhesion must be chosen differently depending on the composition of the layers in contact and on any process undergone by the surface on which the deposition takes place.

In the case where the materials are e.g. silicon oxides, doped or not, to increase adhesion between the layers of dielectric materials some known techniques consist of treating appropriately the free surface where the deposition takes place.

In order to ensure adhesion between the layers of a semiconductor device it has been proposed to increase mechanically the roughness of the surface and hence the gripping area for the reagents to be deposited. One known solution calls for bombardment of the surface by means of the so-called sputtering technique with nitrogen or inert gas ions, e.g. argon, in plasma. This solution is commonly applied in the case if silicon oxides and in particular for the silicon oxides deposited using TEOS (tetraethylorthosilicate) as chemical precursor for the silicon.

Another type of solution proposed by the prior art is usable in the case where the surface incorporates spurious chemical elements, e.g. residues of a previous etching process. In this case, to improve the chemical uniformity of the interface there is performed a cleaning by means of chemical etching in plasma (dry etching) with ions of various types, e.g. oxygen or mixtures of N2 and NH3, or in solution (wet etching).

These techniques, optionally used in succession, are not however sufficiently effective to prevent detachment of adjacent layers in case they include silicon oxynitrides and silicon nitrides. These materials exhibit an intrinsic stress particularly high and therefore the above mentioned mechanical and chemical methods for improvement of the deposition surface are not effective.

Where the adjacent layers include silicon oxynitrides and silicon nitrides it has been proposed, e.g. as described in European patent application EP-A-0627763 of this applicant, to interpose between adjacent layers of dielectric material a layer of oxide and in particular silicon dioxide, i.e. stoichiometric silicon oxide, either doped or not.

This technique exhibits the disadvantage of being effective mainly where the layers of dielectric material consist of silicon nitrides and oxynitrides. This technique in particular is ineffective if used for silicon oxides layers.

A silicon complex having the composition SiCₓO_{y} is known from WO-A-90/09883 where the carbon content is for example, 25%.

An adhesion-inproving, layer between two 50G layers in known from JP-A-6181201, wherein the adhesion layer is a ceramic film containing silicon, oxygen and preferably carbon.

The technical problem underlying the present invention is to ensure effective adhesion between layers of a semiconductor device regardless of the chemical constitution thereof and of the characteristics of their surface level.

### Summary of the invention

The technical problem underlying the present invention is solved by a method for manufacturing a semiconductor device with improved adhesion at the interface between layers of dielectric material, in which is formed an adhesion layer comprising a non-stoichiometric silicon oxide incorporating a certain percentage of carbon (claim 1). A corresponding semiconductor device is set out in claim 10.

A non stoichiometric silicon oxide material of the invention is set out in claim 14.

In accordance with the present invention it was surprisingly found that the presence of carbon in the adhesion layer allows achieving effective adhesion between a first dielectric material layer and a second dielectric material layer superimposed in a semiconductor device, regardless of the chemical composition and the surface condition of the layers. Said layer is formed before formation of the second dielectric layer at low temperature and in an atmosphere kept essentially free from exogenous oxidative substances. In this description, by exogenous oxidative substances is meant oxidative substances, and in particular oxygen, which do not come from the same molecules providing the silicon and the carbon for the layer. Said adhesion layer is thin if compared with the thicknesses of the two layers of dielectric material between which it is interposed.

### Detailed description

In accordance with the present invention in the field of application of integrated semiconductor electronic devices a method for manufacturing a device with improved adhesion at the interface between layers of dielectric material comprises initially operations of the usual type for manufacturing integrated circuits. An integrated circuit structure is formed in a semiconductor material substrate, e.g. monocrystalline silicon. By convention we shall use shortly the term structure to refer indiscriminately to an integrated circuit at the end of its formation, i.e. after formating the metallization strips, or to a device in a different manufacturing step. In any case, usually a structure includes layers of conductive material in its upper parts.

On the structure is superimposed a first layer of protective dielectric material conformal to the structure itself. The dielectric material can be e.g. silicon oxide, silicon nitride or silicon oxynitride, depending on the function it is to fulfil. It is known for example that silicon oxynitrides and silicon nitrides serve adequately as a barrier against diffusion of water and sodium from the outside into the device. For this reason layers of silicon oxynitrides and silicon nitrides are used commonly in the field of devices encapsulated in plastic packages which, as known, do not insulate against moisture and other external contaminants.

Formation of the first dielectric material layer takes place in the conventional manner, usually by means of one of the techniques of low pressure chemical vapour deposition (LPCVD), atmospheric pressure chemical vapour deposition (APCVD), or subatmospheric pressure chemical vapour deposition (SACVD), or by plasma enhancement (PECVD).

Successively there can be performed intermediate operations as described above, e.g. formation of a sacrificial layer with successive etching of the layer itself or only partial etching of the dielectric layer. Within the scope of the present invention the free top surface, as it appears in this phase of manufacturing the device and on which will be formed the successive layer, leaves uncovered, at least in one zone, portions of the first dielectric material layer.

Next is formation of a second dielectric material layer by techniques analogous to those for formation of the first dielectric material layer. This second layer is superimposed on the first at least in the above said zone.

In accordance with the present invention at the interface between the first and second layers and before formation of the second layer is formed a thin dielectric adhesion layer. It is in contact with the first and second layers of dielectric material in at least said zone. In accordance with the present invention this is a ternary compound of silicon, oxygen and carbon.

For the purposes of the present invention preferably the layer acting as adhesive has a thickness comparably small in relation to the two layers between which it is interposed and on the order of a few nanometers or tens of nanometers. More precisely, for pratical process control reasons, there can be defined a preferential range between 5nm and 50nm. However, for the purpose of the present invention the minimum sufficient thickness is that corresponding to a monatomic layer (monolayer), i.e. a thickness equal to the atomic dimensions (1nm).

In accordance with the present invention the intermediate adhesion layer is obtained at a temperature indicatively lower than 500°C and in an atmosphere kept essentially free of exogenous oxidative substances, i.e. different from those coming only from the molecule used to provide the silicon and the carbon for the layer. In accordance with the present invention the oxidiser, e.g. oxygen, used for oxidation of the silicon, comes from the same molecule providing the silicon and carbon.

In accordance with the preferred embodiment the adhesion layer is formed by plasma enhanced chemical vapour deposition technique. The process temperature is between 100°C and 500°C and the pressure between 0.2-10Torr (0.03-1.33kPa). The chemical precursors for the deposition are introduced into the reactor without introducing a specific precursor for the oxygen as takes place commonly when a compound containing oxygen, e.g. stoichiometric silicon oxide, is to be deposited.

In practice, in the preferred embodiment, there is used a single chemical source, liquid or gaseous, comprising the three chemical elements silicon, oxygen and carbon and optionally hydrogen. The silicon serves for formation of a dielectric of silicon and the oxygen for oxidation of the silicon. The carbon is partially liberated in the form of gas and in part incorporated in the layer.

The source used is chosen from among one of the compounds commonly used in the present art as specific precursors of silicon. Preferably it is tetraethylorthosilicate (known as TEOS) or tetramethylcyclotetrasiloxane (known also as TMCTS) or the like. These compounds commonly constitute the base for the deposition of silicon oxide together with separate oxygen sources.

As a group of compounds useful in the formation of the layer all the metallic - organic molecules containing the species necessary for the deposition, i.e. silicon and oxygen, linked with carbon or other organic groups should be considered. For example 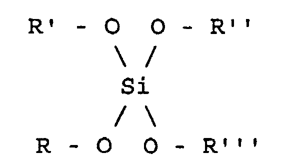 where R','',''' can be any organic group and can be equal to or different from the others and/or can represent other groups containing silicon, oxygen and carbon; or similar molecules.

The formula can be generalised by ⁅0-Si-[O-Rx]₃]ₙ where Rx is an alkylic, aliphatic or aromatic group comprising preferably from 1 to 12 carbon atoms.

The composition and in particular the percentage of carbon contained in the adhesion layer varies depending on the molecule used as precursor and on the conditions generated in the plasma (density, temperature, energy) for formation of the layer.

The deposition in plasma can be the standard PECVD type, i.e. where a radiofrequency generator is used for the production of the plasma. Other types of plasma deposition usable are Electron Cyclotron Resonance (ECR-PECVD) in which are present a microwave generator and there is utilised the known phenomenon of cyclotron resonance or HDCVD (High Density CVD) in which a radiofrequency generator and a magnetic field generator are used simultaneously to increase the plasma density.

The concomitance of the fact that in the process in accordance with the present invention specific oxygen precursors are not included and that the deposition process takes place at a relatively low temperature permits formation of a compound in which is present a percentage of carbon. In the case where one of the two conditions is not satisfied, as takes place in known deposition processes, the compound obtained is pure silicon oxide. Indeed, in the absence of oxygen but at high temperature around 700°C, e.g. using an LPCVD type deposition, the compound obtained is essentially carbon free, as described in the article by S. Rojas, A. Modelli and W.S. Wu in J. Vac. Sci. Technol. B8 (6), Nov/Dec 1990. While on the other hand the use of low temperatures and the addition of oxygen precursors corresponds e.g. to the known deposition of silicon oxide in plasma.

It should be recalled that a negligible presence of exogenous oxygen in relation to the precursors which act in the deposition, e.g. less than a few sccm for a total flow of hundreds of sccm (standard cubic centimetres per minute), falls within the scope of the present invention and can permit modification of the composition of the layer obtained. In addition some molecules used as precursors can require a certain amount of oxygen to modify the carbon concentration in the deposited layer.

Plasma enhancement in accordance with the present invention allows dissociation of the source molecules for the deposition even at the low process temperatures selected.

The adhesion layer obtained by this process comprises preferably the following concentration of atoms, in 10²¹ atoms/cm³:
from 15 to 27 for the silicon,
from 28 to 50 for the oxygen,
from 2.5 to 4.5 for the carbon.

In addition the compound also comprises a small percentage of hydrogen, i.e. from 0.8 * 10²¹ to 1.3 * 10²¹ atoms/cm³.

The presence in this thin adhesion layer of a percentage of carbon in various proportions is decisive for ensuring adhesion between the two layers of dielectric material between which it is interposed.

The adhesion takes place experimentally for every type of dielectric layer whether silicon oxynitrides or silicon nitrides or silicon oxides. In the latter case a layer of stoichiometric silicon oxide, used in the prior art already described, does not give satisfactory results. And on the other hand the method in accordance with the present invention is valid, similarly to the prior art, even for adhesion between layers of silicon oxynitrides and silicon nitrides.

The effectiveness of the method is shown by the absence of peeling between the two layers of dielectric material when the entire structure is subjected to severe stress, e.g. when is deposited over it a thick layer (0.8-1.0 micrometres) of tungsten or other layers with high tensile or compressive stress.

The method in accordance with the present invention in its preferred embodiment does not involve an expenditure in terms of additional process steps as compared with the prior art. The method is also easy to implement using known equipment and techniques.

The low process temperature also allows its use in an electronic device over conductive strips which, as known, would be damaged by high temperatures.

The described method can of course be reiterated to permit adhesion between a third dielectric material layer formed subsequently and the second layer and so on.

In accordance with another aspect of the present invention there is made available a ternary dielectric compound particularly suitable for use as adhesion layer between superimposed dielectric materials as defined in the characterising part of claim 14 and following.

The present invention provides more precisely a ternary dielectric compound of silicon, oxygen and carbon, of composition already described above in detail. It is usable in particular but not exclusively as an adhesive compound between dielectric material layers in an integrated semiconductor electronic device. But it can be used advantageously also outside the above indicated field of application, e.g. in a semiconductor device for optoelectronics or even for adhesion between dielectric layers, e.g. transparent or reflecting layers, in conventional optical applications.

A process for the deposition of a layer of dielectric compound comprising silicon is described. The layer is produced by the chemical vapour deposition technique at low temperature and in an atmosphere kept essentially free of exogenous oxidative substances, i.e. in which the oxidiser is contained in the molecules used for providing the species of atoms included in the layer and other than oxygen. In particular there is used a CVD technique in plasma without substantial addition of chemical precursors for the oxygen.

The process has already been described in relation to the formation of the ternary adhesion compound. The type of process can be used however even for the formation of different layers, for the formation of dielectric materials comprising silicon. For example a stoichiometric silicon oxide can be obtained by the process for forming the layer, as claimed and described previously, using a different molecule containing a greater quantity of oxygen to allow complete oxidation of the other species of atoms contained, i.e. of silicon and optionally carbon. In addition, with different molecules, containing e.g. nitrogen, there can be obtained deposition e.g. of layers of silicon nitride (Si₃N₄) or silicon oxynitride (SiOₓN_{y}).

The characteristics and advantages of the method in accordance with the present invention are set forth in the description of an embodiment thereof given below by way of non-limiting example with reference to the annexed drawings.

### Brief description of the drawings

In the drawings:
FIG. 1 shows a cross section view not in scale of a semiconductor device wherein is present an adhesion layer in accordance with the present invention,
FIG. 2 shows ERDA spectra of two samples of the adhesion layer in accordance with the present invention,
FIG. 3 shows nuclear reaction spectra for the same samples as of the above FIG.,
FIGS. 4 and 5 show respective RBS spectra of the sample of FIG. 2, and
FIG. 6 shows a SIMS spectrum of an electronic device comprising the superimposition of two dielectric layers with an interposed adhesion layer in accordance with the present invention.

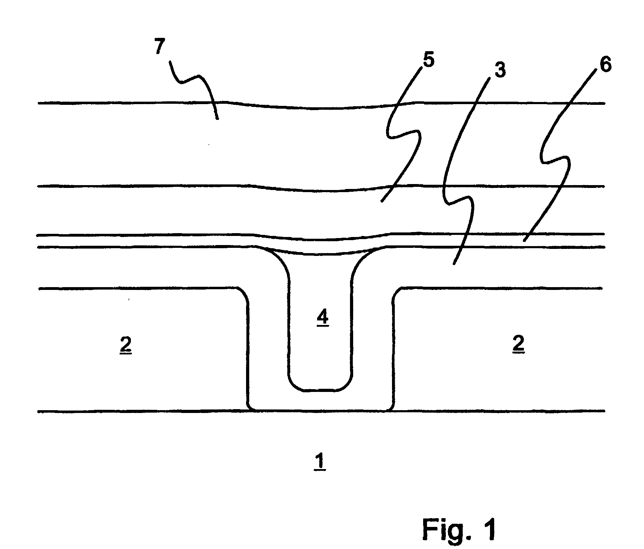

FIG. 1 shows schematically a semiconductor device with improved adhesion between dielectric material layers where the method in accordance with the present invention has been used. Reference number 1 indicates a substrate of semiconductor material on which has been formed previously a circuit structure indicated as a whole by 2 and typically including in the upper part a first layer of conductive material (metallization). To said structure is conformal a first layer of dielectric material 3. Over this has been formed a layer 4 of planarizing material, e.g. SOG (Spin On Glass), in the deeper regions of the structure obtained. The second layer of dielectric material is indicated by 5. As may be seen between the two layers 3 and 5 is formed the thin adhesion layer 6, in contact with both the layers in the region over the structure 2 where there is no layer 4. 7 indicates a second layer of conductive material.

In accordance with a preferred embodiment of formation of an adhesion compound in accordance with the present invention there was used a reaction chamber comprising a standard radiofrequency reactor of the single wafer type. The electrode spacing was 205mils (thousandths of an inch) and the power of the plasma reactor was 430W. A flow of TEOS in an inert gas (He) with the function of carrier for the reagents, totalling as a whole 600sccm (standard cubic centimeters per minute), was introduced into the reaction chamber without introducing oxidising agents. The process temperature was adjusted to 390°C (set point) and pressure to 9Torr (1.20kPa).

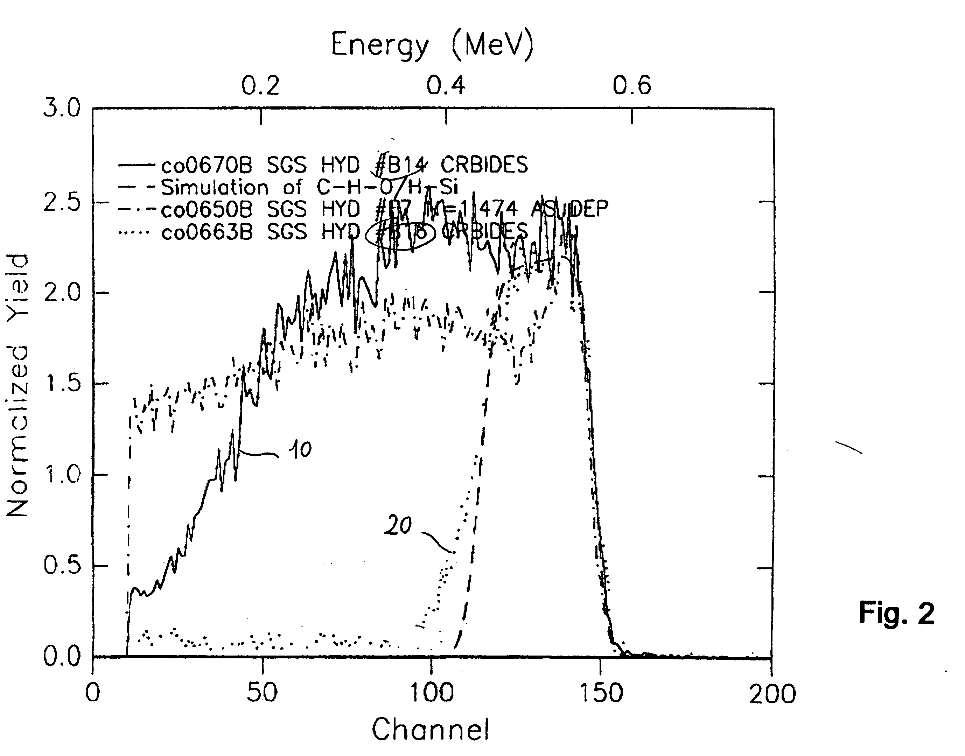

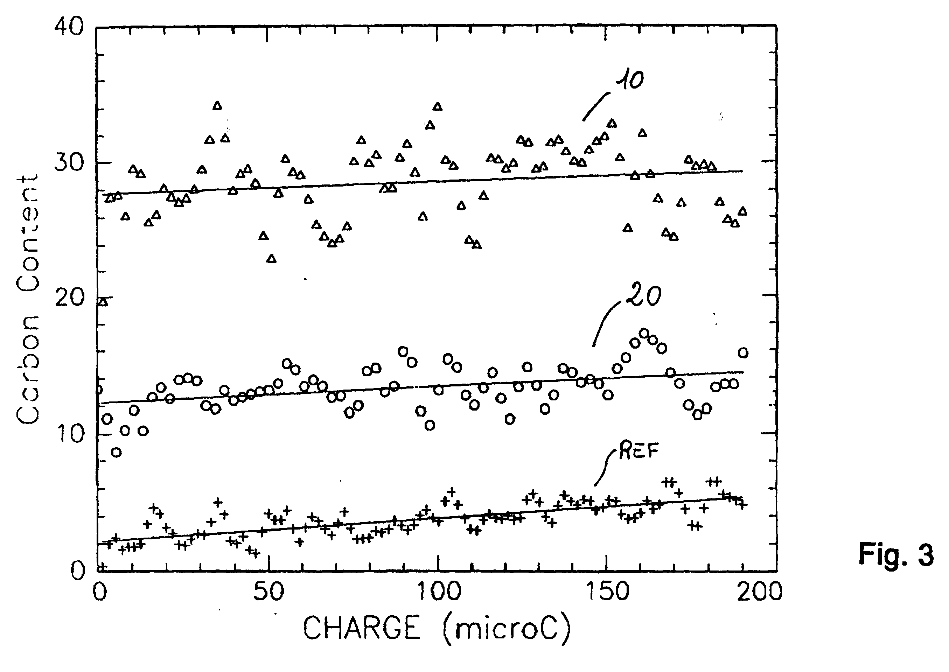

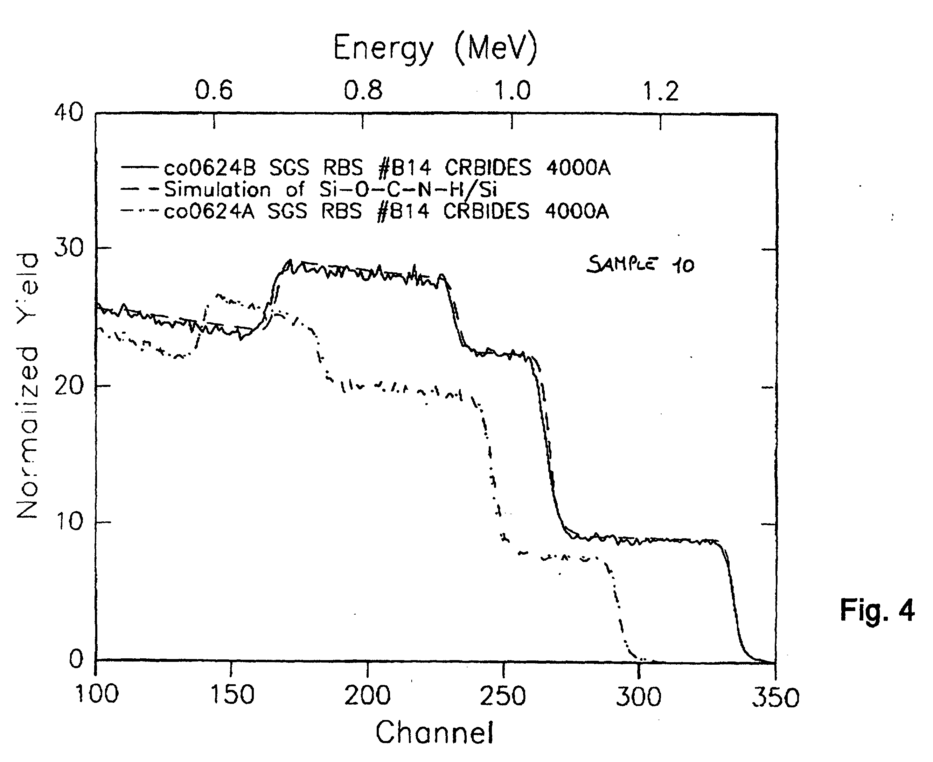

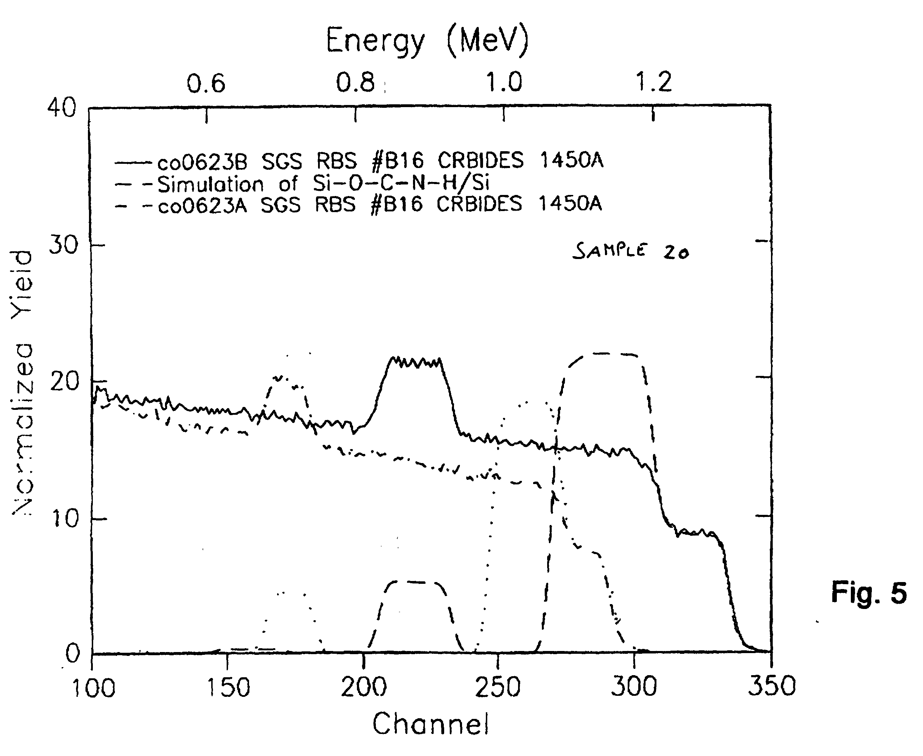

Two different adhesion compound samples formed with these parameters were analysed to determine the composition of the adhesion layer. The two samples were obtained by large scale deposition on dielectric material. In FIGS. 2, 3, 4 and 5 are shown the results. The two samples are indicated by 10 and 20 in the FIGS. and differ in thickness, i.e. 360nm for the first (10) and 150nm for the second (20). The analyses are of the nuclear type. In particular there were made an RBS (Rutherford Backscattering Spectrometry) analysis to determine the silicon and oxygen concentrations using a beam of alpha particles in a particle accelerator; an ERDA analysis to define the hydrogen concentration; and an analysis of nuclear reactions caused by neutrons to determine the content of oxygen, nitrogen and carbon. FIG. 2 shows a spectrum obtained by ERDA. The quantity of hydrogen, essentially negligible, is approximately the same as is present in a silicon oxide obtained by TEOS in accordance with an ordinary technique. FIG. 3 shows the result of an analysis of nuclear reactions for the carbon. In particular there is shown the variation of the concentration as a function of the charge during measurement. The sample indicated by REF is used as reference. FIGS. 4 and 5 show the RBS spectra for the two specimens separately as achieved at two different angles and with superimposed simulated theoretical curves.

The average concentrations extracted by these measurements are summarised in Table 1 where they appear as 10²¹ atoms/cm³.

**Table 1**

| Si | O | C | H |
|---|---|---|---|
| 21.0 | 39.5 | 3.47 | 1.09 |

In a typical example an application of the process in accordance with the present invention is for an intermetal passivation step of an electronic device. The process calls initially for the formation of a first silicon oxide layer on a circuit structure. Formation of the silicon oxide takes place by plasma enhanced chemical vapour deposition and using TEOS as precursor for the silicon. By translation we shall briefly indicate the compound obtained by TEOS. After deposition there follows an etching process and a successive surface cleaning performed by standard techniques. Next a dielectric adhesion layer obtained by the process described above is formed and is followed by deposition of a second layer of TEOS.

The results of adhesion tests are shown in Table 2 and compared with standard methods for adhesion improvement. The tests are performed by placing over the structure a highly stressing layer comprising titanium and titanium nitride. As may be seen, only the structure comprising the adhesion layer in accordance with the present invention exhibits a negligible peeling area a few days after deposition of the titanium.

**Table 2**

| Process used | Peeling start time | wafer peeling time | Area peeled after 120h in cm² |
|---|---|---|---|
| EB:std clean + adhesion layer | 8-72h | - | <0.1 |
| EB:100W/30mT/67s | 20min | 8-72h | - |
| EB:200W/30mT/34s | <1min | - | 130 |
| EB:450W/30mT/14s | <1min | - | 130 |
| EB:300W/240mT/38s | <1min | 3h | - |
| EB:450W/240mT/21s | <1min | 5h | - |
| EB:200W/240mT/102s | <1min | 3h | - |
| EB:300W/17mT/20s | 20min | - | 100 |
| EB:no clean | <1sec | <1min | - |
| EB:std | 3.25h | - | 50 |

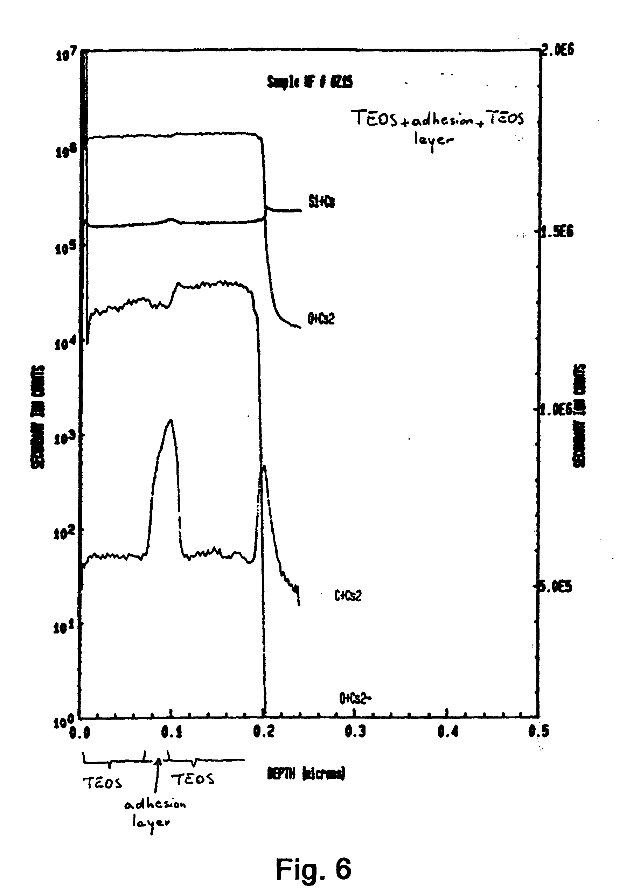

In addition FIG. 6 shows the SIMS (Secondary Ion Mass Spectroscopy) spectrum performed on the same structure TEOS/adhesion layer /TEOS described above. This shows clearly the presence of carbon in the adhesion layer. It should be remembered that by this measurement technique it is possible to determine quantitatively the concentration of the chemical elements in the layer directly on the finished device, differently from nuclear measurement, taking as standard those obtained by the quantitative nuclear measurements.

Of course modifications and variations can be made to the method described above by way of nonlimiting example all however falling within the protective scope of the following claims.

## Claims

1. Method for manufacturing a semiconductor device having improved adhesion at the interface between layers of silicon oxide, silicon nitride or silicon oxynitride, comprising the steps of:
forming a first layer of silicon oxide, silicon nitride or silicon oxynitride (3) on at least one part of a structure (2) defined in a substrate of semiconductor material (1), and
forming a second layer of silicon oxide, silicon nitride or silicon oxynitride (5) superimposed on at least one zone of the first layer,
**characterised in that** it comprises the additional step of forming in said at least one zone wherein said first and second layers are superimposed an intermediate adhesion layer (6) comprising a non stoichiometric silicon oxide incorporating carbon, said carbon being contained into the silicon oxide in a range from 2.5 *10²¹ to 4.5 *10²¹ atoms/cm3.

2. Method in accordance with claim 1 **characterised in that** the step of forming said intermediate adhesion layer (6) is performed at a temperature less than 500°C and in an atmosphere kept essentially free from exogenous oxidative substances.

3. Method in accordance with claim 2 **characterised in that** said intermediate adhesion layer (6) is obtained by means of plasma enhanced chemical vapour deposition.

4. Method in accordance with claim 3 **characterised in that** said intermediate adhesion layer (6) is obtained by plasma enhanced chemical vapour deposition of at least one compound in the group ⁅OSi[ORx]3]n where Rx is an alkylic, aliphatic or aromatic group comprising preferably from 1 to 12 carbon atoms.

5. Method in accordance with claim 4 **characterised in that** said at least one compound is chosen in
the group comprising tetraethylorthosilicate and tetramethylcyclotetrasiloxane and their mixtures.

6. Method in accordance with claim 2 **characterised in that** the step of forming said intermediate adhesion layer (6) is performed at a temperature between 100°C and 500°C and at a pressure between 0.03kPa and 1.30kPa (0.210Torr).

7. Method in accordance with claim 1 **characterised in that** said non stoichiometric silicon oxide comprises:
from 15 *10²¹ to 27 *10²¹ atoms/cm3 of silicon,
from 28 *10²¹ to 50 *10²¹ atoms/cm3 of oxygen.

8. Method in accordance with claim 7 **characterised in that** said non stoichiometric silicon oxide also comprises from 0.8 *10²¹ to 1.3 *10²¹ atoms/cm3 of hydrogen.

9. Method in accordance with claim 1 **characterised in that** the thickness of said intermediate adhesion layer (6) is between 1nm and 50nm.

10. Semiconductor device of the type comprising:
a first layer of silicon oxide, silicon nitride or silicon oxynitride (3) placed on at least one part of a structure (2) defined in a substrate (1) of semiconductor material,
a second layer of silicon oxide, silicon nitride or silicon oxynitride (5) superimposed on at least one zone of the first layer (3), and
an adhesion layer (6) interposed between said layers corresponding to said at least one zone where they are superimposed, **characterised in that** the intermediate adhesion layer (6) comprises a non stoichiometric silicon oxide incorporating carbon, said carbon being content into the silicon oxide in a range from 2.5 *10²¹ to 4.5 *10²¹ atoms/cm3.

11. Semiconductor device in accordance with claim 10 **characterised in that** said non stoichiometric silicon oxide comprises:
from 15 *10²¹ to 27 *10²¹ atoms/cm3 of silicon,
from 28 *10²¹ to 50 *10²¹ atoms/cm³ of oxygen.

12. Semiconductor device in accordance with claim 11 **characterised in that** said non stoichiometric silicon oxide also comprises from 0.8 *10²¹ to 1.3 *10²¹ atoms/cm3 of hydrogen.

13. Semiconductor device in accordance with claim 10 **characterised in that** the thickness of said intermediate adhesion layer is between 1nm and 50nm.

14. Non stoichiometric silicon oxide incorporating carbon for use as an adhesion-enhancement layer betweeen superimposed layers of silicon oxide, silicon nitride or silicon oxynitride (3,4) comprising:
from 15 *10²¹ to 27 *10²¹ atoms/cm3 of silicon,
from 28 *10²¹ to 50 *10²¹ atoms/cm3 of oxygen, and
from 2.5 *10²¹ to 4.5 *10²¹ atoms/cm3 of carbon.

15. Silicon oxide in accordance with claim 14 **characterised in that** it also comprises from 0.8 *10²¹ to 1.3 *10²¹ atoms/cm3 of hydrogen.

16. Silicon oxide in accordance with claim 14 **characterised in that** it is in the form of a layer of thickness between 1nm and 50nm.

## Revendications

1. Méthode pour la fabrication d'un procédé de semi-conducteur améliorant l'adhérence au niveau de l'interface entre les couches d'oxyde de silicium, de nitrile de silicium ou d'oxynitrile de silicium comprenant les étapes suivantes :
- formation d'une première couche d'oxyde de silicium, de nitrile de silicium ou d'oxynitrile de silicium (3) sur tout au moins une partie de la structure (2) définie dans la surface à revêtir du matériau du semi-conducteur (1) et
- formation d'une seconde couche d'oxyde de silicium, de nitrile de silicium ou d'oxynitrile de silicium (5) superposée à au moins une partie de la première couche,
**caractérisée par** l'ajout de ladite formation à au moins une partie où lesdites première et deuxième couches sont superposées au moyen d'une couche d'adhérence (6) englobant un oxyde de silicium non stoechiométrique contenant du carbone, lequel carbone entre dans la composition de l'oxyde de silicium dans des proportions variant de 2.5 * 10²¹ à 4.5 * 10²¹ atomes/cm³.

2. Méthode conformément à la revendication 1,
**caractérisée en ce que** l'étape de formation de ladite couche intermédiaire (6) est réalisée à une température inférieure à 500° C et à une atmosphère purifiée de toute substance oxydante.

3. Méthode conformément à la revendication 2,
**caractérisée par** ladite couche intermédiaire d'adhérence (6) obtenue par des moyens techniques de plasma améliorés par dépôt chimique en phase vapeur.

4. Méthode conformément à la revendication 3,
**caractérisée par** ladite couche intermédiaire d'adhérence (6) est obtenue par des techniques de plasma améliorées par dépôt chimique en phase vapeur d'au moins un composant dans le groupe Eosi[ORx]3]n où Rx est un composant soit alcoyle (alkyle), soit aliphatique ou aromatique incluant de préférence de 1 à 12 atomes de carbone.

5. Méthode conformément à la revendication 4,
**caractérisée par** au moins un composant choisi dans le groupe incluant tétraéthylorthosilicate et tétraméthylcyclatétrasyloxane et leur mélange.

6. Méthode conformément à la revendication 2., **caractérisée par** la formation de ladite couche intermédiaire d'adhérence (6) réalisée à une température comprise entre 100° C et 500° C ainsi qu'à une pression comprise entre 0.03 kPa et 1.30 kPa (0.210 Torr).

7. Méthode conformément à la revendication 1,
**caractérisée par** un oxyde de silicium non stoechiométrique incluant :
de 15 *10²¹ à 27 * 10²¹ atomes/cm³ de silicium
de 28 * 10²¹ à 50 * 10²¹ atomes/cm³ d'oxygène.

8. Méthode conformément à la revendication 7,
**caractérisée par** un oxyde de silicium non stoechiométrique incluant aussi de 0.8 * 10²¹ à 1.3 * 10²¹ atomes/cm³ d'hydrogène.

9. Méthode conformément à la revendication 1,
**caractérisée par** l'épaisseur de ladite couche intermédiaire d'adhérence (6) comprise entre 1 nm et 50 nm.

10. Dispositif semi-conducteur de type comprenant :
- une première couche d'oxyde de silicium, de nitrile de silicium ou d'oxynitrile de silicium (3) placée sur au moins une partie de la structure (2) définie dans la surface (1) à revêtir du matériau du semi-conducteur,
- une deuxième couche d'oxyde de silicium, de nitrile de silicium ou d'oxynitrile (5) superposée à au moins une partie de la première couche (3) et,
- une couche adhérente (6) placée entre les deux couches précitées en adéquation avec au moins le principe d'une zone de superposition ; cette couche d'adhérence (6) est constituée d'un oxyde de silicium non stoechiométrique englobant du carbone, lequel entre dans la composition de l'oxyde de silicium dans des proportions variant entre 2.5 * 10²¹ et 4.5*10²¹ atomes/cm³.

11. Dispositif semi-conducteur conformément à la revendication 10, **caractérisé par** un oxyde de silicium non stoechiométrique comprenant entre 15 * 10²¹ à 27 * 10²¹ atomes /cm³ de silicium et de l'oxygène variant entre 28 * 10²¹ et 50 * 10²¹ atomes/cm³ .

12. Dispositif semi-conducteur conformément à la revendication 11, **caractérisé par** un oxyde de silicium non stoechiométrique incluant aussi de 0.8 * 10²¹ à 1.3 * 10²¹ atomes/cm³ d'hydrogène.

13. Dispositif semi-conducteur conformément à la revendication 10, **caractérisé par** l'épaisseur de la couche intermédiaire d'adhérence qui varie entre 1 nm et 50 nm.

14. Oxyde de silicium non stoechiométrique incluant du carbone utilisé pour renforcer la couche d'adhérence entre les deux couches superposées d'oxyde de silicium, de nitrile de silicium ou d'oxyde de nitrile de silicium comprenant :
- du silicium variant de 15 * 10²¹ à 27 * 10²¹ atomes/cm³
- de l'oxygène variant de 28 * 10²¹ à 50 * 10²¹ atomes/cm³.
- du carbone variant de 2.5 * 10²¹ à 4.5 * 10²¹ atomes/cm³

15. Oxyde de silicium conformément à la revendication 14, **caractérisé par** la présence d'hydrogène variant de 0.8 * 10²¹ à 1.3 * 10²¹ atomes/cm³.

16. Oxyde de silicium conformément à la revendication 14, **caractérisé par** la formation d'une couche d'épaisseur comprise entre 1 nm et 50 nm.

## Patentansprüche

1. Verfahren zum Herstellen eines Halbleiter-Bauelements mit verbesserter Adhäsion an der Trennfläche zwischen Schichten aus Siliziumoxid, Siliziumnitrid oder Siliziumoxynitrid,
umfassend die folgenden Schritte:
Bilden einer ersten Schicht aus Siliziumoxid, Siliziumnitrid oder Siliziumoxynitrid (3) an mindestens einem Teil eines Aufbaus (2), der in einem Substrat aus Halbleitermaterial (1) definiert ist, und
Bilden einer zweiten Schicht aus Siliziumoxid, Siliziumnitrid oder Siliziumoxynitrid (5), die mindestens eine Zone der ersten Schicht überlagert,
**dadurch gekennzeichnet, dass** es den zusätzlichen Schritt des Bildens einer Adhäsions-Zwischenschicht (6), die ein nicht stöchiometrisches, Kohlenstoff aufweisendes Siliziumoxid umfasst, wobei der Kohlenstoff in dem Siliziumoxid im Bereich von 2,5 *10²¹ bis 4,5 *10²¹ Atome/cm³ enthalten ist, in der mindestens einen Zone, in der die erste und zweite Schicht überlagert sind, umfasst.

2. Verfahren nach Anspruch 1, **dadurch gekennzeichnet, dass** der Schritt des Bildens der Adhäsions-Zwischenschicht (6) bei einer Temperatur von weniger als 500°C und in einer Atmosphäre durchgeführt wird, die im Wesentlichen frei von exogenen oxidativen Substanzen gehalten wird.

3. Verfahren nach Anspruch 2, **dadurch gekennzeichnet, dass** die Adhäsions-Zwischenschicht (6) mittels plasmaverstärkten chemischen Aufdampfens erhalten wird.

4. Verfahren nach Anspruch 3, **dadurch gekennzeichnet, dass** die Adhäsions-Zwischenschicht (6) durch plasmaverstärktes chemisches Aufdampfen von mindestens einer Verbindung in der Gruppe ⁅OSi[ORx]3]n erhalten wird, wobei Rx eine Alkylgruppe, eine aliphatische oder aromatische Gruppe ist, die vorzugsweise 1 bis' 12 Kohlenstoffatome umfasst.

5. Verfahren nach Anspruch 4, **dadurch gekennzeichnet, dass** die mindestens eine Verbindung aus der Gruppe ausgewählt ist, die Tetraethylorthosilicat und Tetramethylcyclotetrasiloxan und deren Gemische umfasst.

6. Verfahren nach Anspruch 2, **dadurch gekennzeichnet, dass** der Schritt des Bildens der Adhäsions-Zwischenschicht (6) bei einer Temperatur zwischen 100°C und 500°C und bei einem Druck zwischen 0,03 kPa und 1,30 kPa (0,210 torr) durchgeführt wird.

7. Verfahren nach Anspruch 1, **dadurch gekennzeichnet, dass** das nicht stöchiometrische Siliziumoxid folgendes umfasst:
15 *10²¹ bis 27 *10²¹ Atome/cm³ Silizium,
28 *10²¹ bis 50 *10²¹ Atome/cm³ Sauerstoff.

8. Verfahren nach Anspruch 7, **dadurch gekennzeichnet, dass** das nicht stöchiometrische Siliziumoxid auch 0,8 *10²¹ bis 1,3 *10²¹ Atome/cm3 Wasserstoff umfasst.

9. Verfahren nach Anspruch 1, **dadurch gekennzeichnet, dass** die Dicke der Adhäsions-Zwischenschicht (6) zwischen 1 nm und 50 nm beträgt.

10. Halbleiter-Bauelement der Bauart, umfassend:
eine erste Schicht aus Siliziumoxid, Siliziumnitrid oder Siliziumoxynitrid (3), die auf mindestens einem Teil eines Aufbaus (2) angeordnet ist, die in einem Substrat (1) eines Halbleitermaterials definiert ist,
eine zweite Schicht aus Siliziumoxid, Siliziumnitrid oder Siliziumoxynitrid (5), die mindestens eine Zone der ersten Schicht (3) überlagert, und
eine Adhäsionsschicht (6), die zwischen den Schichten angeordnet ist, die der mindestens einen Zone, in der sie übereinander angeordnet sind, entsprechen, **dadurch gekennzeichnet, dass** die Adhäsions-Zwischenschicht (6) ein nicht stöchiometrisches, Kohlenstoff enthaltendes Siliziumoxid umfasst, wobei der Kohlenstoff im Siliziumoxid im Bereich von 2,5 *10²¹ bis 4,5 *10²¹ Atome/cm³ enthalten ist.

11. Halbleiter-Bauelement nach Anspruch 10, **dadurch gekennzeichnet, dass** das nicht stöchiometrische Siliziumoxid folgendes umfasst:
von 15 *10²¹ bis 27 *10²¹ Atome/cm³ Silizium,
von 28 *10²¹ bis 50 *10²¹ Atome/cm³ Sauerstoff.

12. Halbleiter-Bauelement nach Anspruch 11, **dadurch gekennzeichnet, dass** das nicht stöchiometrische Siliziumoxid auch 0,8 *10²¹ bis 1,3 *10²¹ Atome/cm³ Wasserstoff umfasst.

13. Halbleiter-Bauelement nach Anspruch 10, **dadurch gekennzeichnet, dass** die Dicke der Adhäsions-Zwischenschicht zwischen 1 nm und 50 nm beträgt.

14. Nicht stöchiometrisches, Kohlenstoff enthaltendes Siliziumoxid zur Verwendung als Adhäsions-Verstärkungsschicht zwischen überlagerten Schichten aus Siliziumoxid, Siliziumnitrid oder Siliziumoxynitrid (3,4), umfassend:
15 *10²¹ bis 27 *10²¹ Atome/cm³ Silizium,
28 *10²¹ bis 50 *10²¹ Atome/cm³ Sauerstoff und
2,5 *10²¹ bis 4,5 *10²¹ Atome/cm³ Kohlenstoff.

15. Siliziumoxid nach Anspruch 14, **dadurch gekennzeichnet, dass** es auch 0,8 *10²¹ bis 1,3 *10²¹ Atome/cm³ Wasserstoff umfasst.

16. Siliziumoxid nach Anspruch 14, **dadurch gekennzeichnet, dass** es in der Form einer Schicht mit einer Dicke zwischen 1 nm und 50 nm vorliegt.
